**Europäisches Patentamt**

**European Patent Office**

**Office européen des brevets**

(11) Veröffentlichungsnummer: **0 412 567 A2**

# (12) EUROPÄISCHE PATENTANMELDUNG

(21) Anmeldenummer: 90115416.1

(22) Anmeldetag: **10.08.90**

(51) Int. Cl.5: **H03K 19/0185**, H03K 19/0948, H03K 17/30

(30) Priorität: **10.08.89 DE 3926521**

(43) Veröffentlichungstag der Anmeldung:
**13.02.91 Patentblatt 91/07**

(84) Benannte Vertragsstaaten:
**DE FR GB IT NL**

(71) Anmelder: **Siemens Aktiengesellschaft**
**Wittelsbacherplatz 2**
**D-8000 München 2(DE)**

(72) Erfinder: **Barré, Claude, Dipl.-Ing.**
**Implerstrasse 23**
**D-8000 München 70(DE)**

(54) **Integrierbare Transistorschaltstufe mit einstellbarer Schaltschwelle.**

(57) Eine integrierbare Transistorschaltstufe mit einer von einem vorgebbaren Referenzspannungswert abhängigen Schaltschwelle wird durch einen CMOS-Inverter gebildet, der in Serie zwischen zwei zueinander komplementäre Laststrom-Feldeffekttransistoren (Q1, Q2) geschaltet ist. Die Gate-Elektroden der beiden Laststrom-Feldeffekttransistoren (Q1, Q2) sind miteinander verbunden und werden von einer Referenzspannung (VREF) beaufschlagt. Durch Dimensionierung der Transistoren läßt sich für die Schaltschwelle ein Einstellbereich vorgeben, in dem die Übertragungskennlinie der Transistorschaltstufe einen günstigen Verlauf aufweist.

FIG 3

EP 0 412 567 A2

# INTEGRIERBARE TRANSISTORSCHALTSTUFE MIT EINSTELLBARER SCHALTSCHWELLE

Die Erfindung betrifft eine integrierbare Transistorschaltstufe gemäß dem Oberbegriff des Patentanspruchs 1.

In der Digitaltechnik werden Transistorschaltstufen häufig auch als Signalpegelwandler eingesetzt und dienen vor allem dazu, den von einem Eingangssignalpegel repräsentierten binären Wert zu identifizieren und einen zur Repräsentation dieses binären Wertes vorgesehenen Ausgangssignalpegel zu erzeugen. In vielen Fällen invertiert ein Signalpegelwandler den identifizierten binären Wert und führt damit zusätzlich zur Pegelwandlung noch eine logische Negatorfunktion aus.

Damit ein jeweiliger Eingangssignalpegel mit möglichst großer Sicherheit richtig identifiziert werden kann, muß die Schaltschwelle des Signalpegelwandlers möglichst genau in der Mitte zwischen den Spannungswerten der, den logischen Null- und Eins-Werten zugeordneten Signalpegel des Eingangssignales liegen.

Zur Realisierung eines Signalpegelwandlers, dessen Schaltschwelle zur Anpassung an ein jeweiliges Eingangssigani einstellbar ist, ist eine Schaltstufe bekannt, die aus einer Serienschaltung eines N- und eines P-MOS-Feldeffekttransistors mit einem als Schaltausgang dienenden Mittelabgriff besteht. Einer der beiden Feldeffekttransistoren, dessen Gateelektrode als Schalteingang ausgebildet ist, kann als Steuerungstransistor, der andere, an dessen Gateelektrode eine vorgebbare Referenzspannung angeschlossen ist, als Laststromtransistor bezeichnet werden.

Der Laststromtransistor stellt einen in Abhängigkeit des Referenzspannungswertes sich verändernden ohmschen Widerstand dar.

Die Stromstärke durch den Steuerungstransistor hängt demzufolge von der eingestellten Referenzspannung ab, weshalb sich der, ein Umschalten der Schaltstufe bewirkende Wert der Eingangssignalspannung, der als Schaltschwelle bezeichnet wird, je nach eingestelltem Referenzspannungswert zu positiveren bzw. negativeren Spannungswerten hin verschiebt.

Ein höherer Strom durch den Steuerungstransistor bringt aber auf Grund der sich dabei verändernden Drain-Source-Spannung den Nachteil mit sich, daß die Übertragungskennlinie der Schaltstufe flacher wird, d.h. daß der Pegelwechsel am Schaltstufenausgang nicht sprunghaft, sondern allmählich erfolgt.

Diese Tatsache, die insbesondere bei Eingangssignalen mit geringem Störabstand, also mit geringer Spannungsdifferenz zwischen den, den Null- und Eins-Werten zugeordneten Signalpegeln, erhebliche Probleme aufwirft, macht die Schwächen der bekannten Schaltstufe deutlich.

Aufgabe der vorliegenden Erfindung ist es daher, eine Transistorschaltstufe nach dem Oberbegriff des Patentanspruchs 1 so weiterzubilden, daß die Schaltschwelle wenigstens innerhalb eines vorgegebenen Bereiches unter Beibehaltung einer optimalen Übertragungskennlinie veränderbar ist.

Gelöst wird diese Aufgabe erfindungsgemäß durch die im kennzeichnenden Teil des Patentanspruchs 1 angegebenen Merkmale.

Der erfindungsgemäß aufgebauten Schaltstufe liegt ein CMOS-Inverter zugrunde, der für sich betrachtet durch die "Push-Pull"-Betriebsweise seiner beiden komplementären Steuerungs-FET's eine Übertragungskennlinie aufweist, die zum einen als ideal angesehen werden kann, und zum anderen durch Dimensionierung des Größenverhältnisses der beiden Steuerungs-FET's auf eine Schaltschwelle gelegt werden kann, die bei der bekannten Schaltstufe nur unter Inkaufnahme einer ungünstigen Übertragungskennlinie einstellbar ist.

Ein zusätzlicher Vorteil der erfindungsgemäß ausgebildeten Schaltstufe ergibt sich durch den CMOS-Inverter, der gegenüber den bekannten Schaltstufen eine geringere Verlustleistung ermöglicht.

Als weiterer Vorteil kann auch die Tatsache angesehen werden, daß mit den weiteren Transistoren im Hinblick auf ihre Dimensionierung zusätzliche Freiheitsgrade bei einer Integration der Schaltstufe geschaffen werden.

Vorteilhafte Weiterbildungen der Erfindung ergeben sich aus den Unteransprüchen.

Mit einem weiteren Stromlast-FET, der an das jeweilige andere Versorgungsspannungspotential angeschlossen ist, kann die Schaltschwelle des CMOS-Inverters in beide Richtungen verschoben werden.

Eine solche Schaltstufe bietet bei der Dimensionierung der Transistoren drei Freiheitsgrade. Zum einen das Größenverhältnis zwischen den beiden Steuerungs-FET's, mit dem die Schaltschwelle bei idealer Übertragungskennlinie voreingestellt wird; ferner das Größenverhältnis zwischen den beiden Laststrom-FET's, mit dem die Schaltschwelle im Hinblick auf den zur Verfügung stehenden Bereich der Referenzspannung symmetrisiert werden kann; und des weiteren das Verhältnis der Größen zwischen Laststrom und Steuerungs-FET's, mit dem ein Maß für die durch eine Veränderung der Referenzspannung erreichbare Wirkung festgelegt werden kann.

Anhand der Zeichnung werden im folgenden zwei Ausführungsbeispiele näher erläutert. Dabei zeigen

FIG 1 je ein Schaltbild für die Polaritätsvarianten der bekannten Schaltstufe,

FIG 2 Übertragungskennlinien für die bekannte Schaltstufe in beiden Polaritätsvarianten,

FIG 3 ein Schaltbild für eine als Reihenschaltung erfindungsgemäß ausgebildete Schaltstufe,

FIG 4 Übertragungskennlinien für die Schaltstufe nach FIG 3,

FIG 5 ein Schaltbild für eine als Parallelschaltung erfindungsgemäß ausgebildete Schaltstufe.

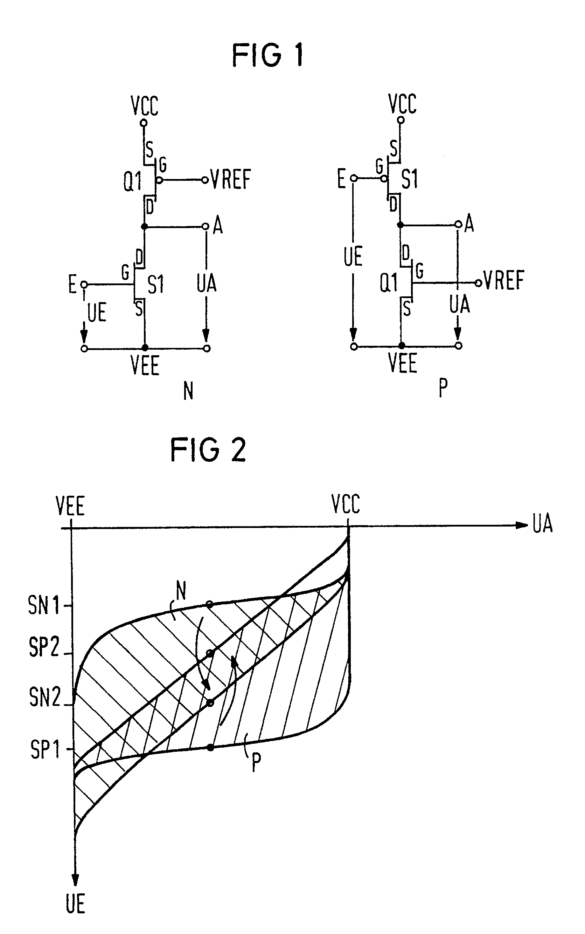

In der FIG 1 sind zwei Schaltbilder für die beiden Polaritätsvarianten der bekannten Schaltstufe dargestellt. Bei der ersten Variante N der Schaltstufe (linkes Schaltbild) ist ein als P-MOS-Feldeffekttransistor, abgekürzt P-MOS-FET, ausgebildeter Laststromtransistor Q1 in Serie mit einem als N-MOS-Feldeffekttransistor, abgekürzt N-MOS-FET, ausgebildeten Steuerungstransistor S1 geschaltet. Die beiden Transistoren Q1, S1 sind an ihren Drainelektroden D miteinander verbunden, wobei diese Verbindung auch als Schaltstufenausgang A dient.

Der Laststromtransistor Q1 ist mit seiner Sourceelektrode S an ein Spannungspotential VCC (z.B. + 5 Volt), der Steuerungstransistor Q2 an ein gegenüber dem Spannungspotential VCC negativeres weiteres Spannungspotential VEE (z.B. 0 Volt) angeschlossen. Die Gateelektrode G des Steuerungstransistors S1 ist als Schaltstufeneingang E ausgebildet und an der Gateelektrode G des Laststromtransistors Q1 liegt eine Referenzspannung VREF.

Die zweite Variante P der bekannten Schaltstufe (rechtes Schaltbild) unterscheidet sich von der ersten Variante N lediglich dadurch, daß der Steuerungstransistor S1 als P-MOS-FET und der Laststromtransistor Q1 als N-MOS-FET ausgebildet und an das Spannungspotential VCC bzw. das weitere Spannungspotential VEE angeschlossen ist.

In der FIG 2 sind Übertragungskennlinien für die erste und zweite Variante N, P der bekannten Schaltstufe dargestellt, aus denen anhand von jeweils zwei Kurven der Wert der Ausgangsspannung UA in Abhängigkeit einer jeweiligen Eingangsspannung UE ersehen werden kann.

Bei der ersten Variante N läßt sich die Schaltschwelle zwischen einem ersten und einem zweiten Eingangsspannungswert SN1, SN2 verschieben. Ist die Source-Gate-Spannung am Laststromtransistor Q1 gering, liegt die Schaltschwelle beim ersten Eingangsspannungswert SN1; die zugehörige Übertragungskennlinie ist relativ steil. Mit zunehmender Source-Gate-Spannung verschiebt sich die Schaltschwelle zum zweiten Eingangsspannungswert SN2, wobei die zugehörige Übertragungskennlinie dann relativ flach ist.

Ein analoges Verhalten gilt für die zweite Variante P der bekannten Schaltstufe, bei der mit zunehmender Gate-Source-Spannung am Laststromtransistor Q1 die Schaltschwelle von einem ersten Eingangsspannungswert SP1 zu einem zweiten Eingangsspannungswert SP2 hin verschoben wird.

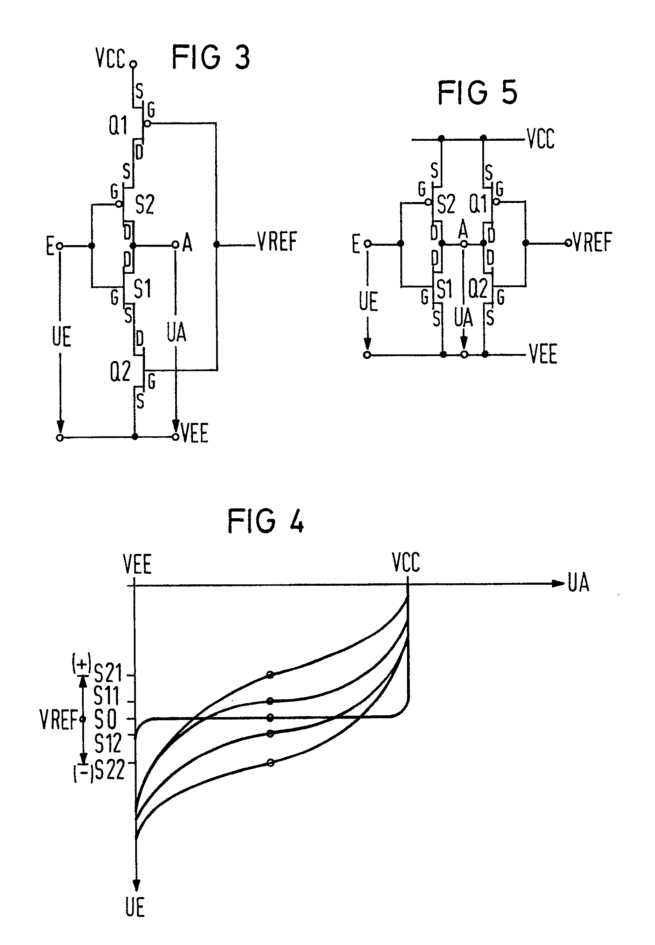

In FIG 3 ist ein Schaltbild einer erfindungsgemäß ausgebildeten Schaltstufe dargestellt, bei dem ein aus Steuerungstransistoren S1, S2 bestehender CMOS-Inverter in Serie zwischen zwei Laststromtransistoren Q1, Q2 geschaltet ist. Der CMOS-Inverter besteht aus einem als N-MOS-FET ausgebildeten Steuerungstransistor S1 und einem als P-MOS-FET ausgebildeten weiteren Steuerungstransistor S2, die sowohl über ihre Drainelektroden D als auch Gateelektroden G miteinander verbunden sind. Die Gateelektroden bilden den Schaltstufeneingang E, und die Drainelektroden den Schaltstufenausgang A.

Der weitere Steuerungstransistor S2 ist mit seiner Sourceelektrode S über die Drain-Source-Strecke eines als P-MOS-FET ausgebildeten Laststromtransistors Q1 an ein Spannungspotential VCC (z.B. + 5 Volt), und der Steuerungstransistor S1 über einen als N-MOS-FET ausgebildeten weiteren Laststromtransistor Q2 an ein gegenüber dem Spannungspotential VCC negativeres weiteres Spannungspotential VEE (z.B. 0 Volt) angeschlossen. Die Gateelektroden der Laststromtransistoren Q1, Q2 sind miteinander verbunden und werden von einer Referenzspannung VREF beaufschlagt.

Die beiden Laststromtransistoren Q1, Q2 können als Korrekturelemente angesehen werden und wirken als gegenphasig zueinander, durch die Referenzspannung VREF verstellbare Widerstände. Je positiver z.B. die Referenzspannung VREF wird, umso größer wird der Widerstand des Laststromtransistors Q1, und umso geringer der Widerstand des weiteren Laststromtransistors Q2. Dies hat zur Folge, daß sich die Schaltschwelle in negativer Richtung, also zum weiteren Spannungspotential VEE hin verschiebt.

Durch eine entsprechende Dimensionierung der Steuer- und Laststrom-Feldeffekttransistoren S1, S2, Q1, Q2, kann eine Schaltschwelle eingestellt werden, die für einen vorliegenden Anwendungsfall optimale Bedingungen bietet. Wie sich die Dimensionierung der Transistoren auf die Schaltschwelle und die Übertragungskennlinie der Schaltstufe auswirkt, wird in Zusammenhang mit der FIG 4 im folgenden näher erläutert.

In der FIG 4 sind Übertragungskennlinien für auf unterschiedlichen Eingangsspannungswerten S0, S11, S12, S21, S22 liegenden Schaltschwellen dargestellt.

Eine sogenannte nominale Schaltschwelle für den Eingangsspannungswert S0 wird bei der erfindungsgemäß ausgebildeten Schaltstufe durch das Größenverhältnis zwischen den beiden Steuertransistoren S1, S2 eingestellt. Die der Nominalschaltschwelle zugehörige Übertragungskennlinie hat einen optimal steilen Verlauf, wenn die beiden Laststromtransistoren als kurzgeschlossen angenommen sind.

Das Größenverhältnis zwischen Steuer- und Laststromtransistoren bestimmt den durch Veränderung der Referenzspannung VREF möglichen Verschiebebereich der Schaltschwelle. Mit gegenüber den Steuerungstransistoren S1, S2 groß ausgebildeten (d.h. mit geringerem Innenwiderstand versehenen) Laststromtransistoren Q1, Q2 hat eine Veränderung der Referenzspannung VREF geringe Wirkung auf eine Verschiebung der Schaltschwelle, jedoch bleibt die Übertragungskennlinie steil. Diesen Fall veranschaulichen in FIG 4 die den Eingangsspannungswerten S11 bzw. S12 zugehörigen Übertragungskennlinien.

Sind die Laststromtransistoren Q1, Q2 kleiner ausgebildet, hat eine Veränderung der Referenzspannung größere Wirkung auf die Verschiebung der Schaltschwelle, jedoch werden die Übertragungskennlinien dann flacher. Dieser Fall soll durch die den Eingangsspannungswerten S21 und S22 zugeordneten Übertragungskennlinien veranschaulicht werden.

Das Größenverhältnis zwischen den beiden Laststromtransistoren Q1, Q2 kann im Falle eines für die Referenzspannung VREF begrenzt zur Verfügung stehenden Spannungsbereiches zur Symmetriesierung verändert werden, so daß die nominale Schaltschwelle z.B. genau dann eingestellt ist, wenn der Referenzspannungswert in der Mitte des für die Bildung der Refenzspannung zur Verfügung stehenden Spannungsbereiches liegt.

In der FIG 5 ist ein Schaltbild für eine erfindungsgemäß ausgebildete Schaltstufe mit zu den Steuerungstransistoren eines CMOS-Inverters parallelgeschalteten Laststromtransistoren dargestellt.

Ein als N-MOS-FET ausgebildeter Steuerungstransistor S1 und ein als P-MOS-FET ausgebildeter weiterer Steuerungstransistor S2 sind über ihre Drain- und Gateelektroden D, G zur Bildung eines CMOS-Inverters miteinander verbunden. Die Sourceelektrode S des Steuerungstransistors S1 ist an das weitere Spannungspotential VEE (z.B. 0 Volt), die Sourceelektrode des weiteren Steuerungstransistors S2 an das positivere Spannungspotential VCC (z.B. 5 Volt) angeschlossen. Weiterhin sind ein als P-MOS-FET ausgebildeter Laststromtransistor Q1 und ein als N-MOS-FET ausgebildeter weiterer Laststromtransistor Q2 über ihre Drain- und Gateelektroden D, G miteinander verbunden und mit ihren Sourceelektroden S an das Spannungspotential VCC bzw. das weitere Spannungspotential VEE angeschlossen.

Die Gateelektroden G der Steuerungstransistoren S1, S2 bilden den Schaltstufeneingang E, und an die Gateelektroden G der Laststromtransistoren Q1, Q2 ist eine Referenzspannung VREF geführt. Mit einer Verbindung der Drainelektroden D zwischen den Steuerungstransistoren S1, S2 und den Laststromtransistoren Q1, Q2 wird der Schaltstufenausgang A gebildet.

Bie dieser Schaltstufe können die beiden Laststromtransistoren Q1, Q2 als Stromquellen angesehen werden. Ist die Referenzspannung VREF so eingestellt, daß sich die Ströme durch die beiden Laststromtransistoren Q1, Q2 aufheben, so wird der CMOS-Inverter nicht beeinflußt und die Nominalschaltschwelle wird durch da Größenverhältnis zwischen den beiden Steuerungstransistoren S1, S2 festgelegt. Die zugehörige Übertragungskennlinie ist entsprechend der eines CMOS-Inverters als ideal anzusehen.

Wird die Referenzspannung VREF in eine positivere Richtung verändert, gibt der weitere Stromlasttransistor Q2 eine höheren Strom als der Stromlasttransistor Q1. Um dies zu kompensieren, muß der weitere Steuerungstransistor S2 gegenüber dem Steuerungstransistor S1 auch einen höheren Strom abgeben. Damit verschiebt sich die Schaltschwelle zu negativeren Werten.

In analoger Weise verschiebt sich die Schaltschwelle in positiver Richtung, wenn die Referenzspannung VREF sich dem Wert des weiteren Spannungspotentials VEE annähert. Die Form der Übertragungskennlinien verändert sich bei dieser Schaltstufe nicht und bleibt für alle möglichen Schaltschwellen ideal.

Mit dem Größenverhältnis zwischen Laststrom- und Steuerungstransistoren kann der Einfluß der Referenzspannung VREF auf eine Verschiebung der Schaltschwelle festgelegt werden. Sind die Laststromtransistoren relativ klein ausgebildet, so kann die Schaltschwelle durch Verändern der Referenzspannung nur in einem geringen Bereich verschoben werden. Sind die Laststromtransistoren dagegen relativ groß ausgebildet, so ist die Schaltschwelle in einem großen Bereich verschiebbar, allerdings muß in diesem Falle mit einer höheren Verlustleistung der Schaltstufe auf Grund eines höheren Permanentstromes durch die beiden Laststromtransistoren Q1, Q2 gerechnet werden.

## Ansprüche

1. Integrierbare Transistorschaltstufe zur Signalpegelwandlung, bestehend aus einem Strompfad, der aus einem mit seiner Drain-Source-Strecke an ein Versorgungsspannungspotential angeschlossenen Laststromfeldeffekttransistor (Q1) und zwei zueinander komplementär ausgebildeten, in bekannter CMOS-Inverterschaltung verbundenen Steuerungsfeldeffekttransistoren (S1,S2) gebildet ist, wobei die Drain-Source-Strecke des zum Laststromfeldeffekttransistor (Q1) komplementär ausgebildeten Steuerungsfeldeffekttransistor (S1) als Verbindung des Strompfades mit einem weiteren Versorgungsspannungspotential dient, die Gateelektroden der Steuerungsfeldeffekttransistoren (S1,S2) gemeinsam als Schaltstufeneingang (E) ausgebildet sind und die Verbindungsleitung der Drain-Source-Strecken der Steuerungsfeldeffekttransistoren (S1,S2) den Schaltstufenausgang (A) bildet,
**dadurch gekennzeichnet**, daß die Schaltschwelle der Transistorschaltstufe durch Beaufschlagen des Gateanschlusses des Laststromfeldeffekttransistors (Q1) mit einer vorgebbaren Referenzspannung (VREF) einstellbar ist.

2. Transistorschaltstufe nach Anspruch 1,
**gekennzeichnet** durch einen zum Laststrom-FET (Q1) komplementär ausgebildeten weiteren Laststrom-FET (Q2), dessen Gateelektrode (G) mit der des Laststrom-FET's (Q1) verbunden ist und dessen Drain-Source-Strecke an das weitere Versorgungsspannungspotential angeschlossen ist.

3. Transistorschaltstufe nach Anspruch 2,
**dadurch gekennzeichnet**, daß der CMOS-Inverter über je einen der Laststrom-FET's (Q1, Q2) an die Versorgungsspannungspotentiale angeschlossen ist.

4. Transistorschaltstufe nach Anspruch 2,
**dadurch gekennzeichnet**, daß die Drain-Sourcestrecke des Laststrom-FET's (Q1) zu der des weiteren Steuerungs-FET's (S2) und die des Steuerungs-FET's (S1) zu der des weiteren Laststrom-FET's (Q2) parallegeschaltet ist.

# FIG 1

# FIG 2

## FIG 3

## FIG 5

## FIG 4